# EUROPEAN PATENT APPLICATION

(11) **EP 1 655 691 A1**
(43) Date of publication of application: **10.05.2006**
(21) Application number: 04292644.4
(22) Date of filing: 08.11.2004
(51) Int. Cl.: G06K 19/077, H01L 21/56

(54) **A smart card micro-electronic module manufacturing method**

(71) Applicant: Axalto SA, 92120 Montrouge (FR)
(72) Inventor: Nerot, Dorothée, c/o Axalto S.A., 92120 Montrouge (FR); Groeninck, Denis, c/o Axalto S.A., 92120 Montrouge (FR); Salib, Rami, c/o Axalto S.A., 92120 Montrouge (FR); Reignoux, Yves, c/o Axalto S.A., 92120 Montrouge (FR); Simonot, Sandrine, c/o Axalto S.A., 92120 Montrouge (FR)

(57) **Abstract**

A method for manufacturing a micro-electronic module for a smart-card comprising the following steps:
- a first gluing step consisting in gluing a transportation layer 18 over a back side of a metallic grid 11 through a removable gluing layer 19,
- a second gluing step consisting in gluing a chip 12 over a front side of the metallic grid 11 through a chip gluing layer 13,
- a connecting step consisting in bonding the chip 12 to the front side of the metal grid 11 by means of at least one connection 14,
- an encapsulating step consisting in encapsulating the chip 12 and the connection 14, and
- a removal step consisting in removing the transportation layer 18 and the removable gluing layer 19 from the back side of the metallic grid 11.

## Description

### FIELD OF THE INVENTION

The invention relates to a method for manufacturing a micro-electronic module and a smart-card.
The invention also relates to a micro-electronic module and a smart-card comprising such a micro-electronic module obtained by such a method.
The invention applied in the smart-card industry. A smart-card is understood as designating any portable object such as a SIM card, a bank card, an access card, a loyalty card, etc....

### BACKGROUND OF THE INVENTION

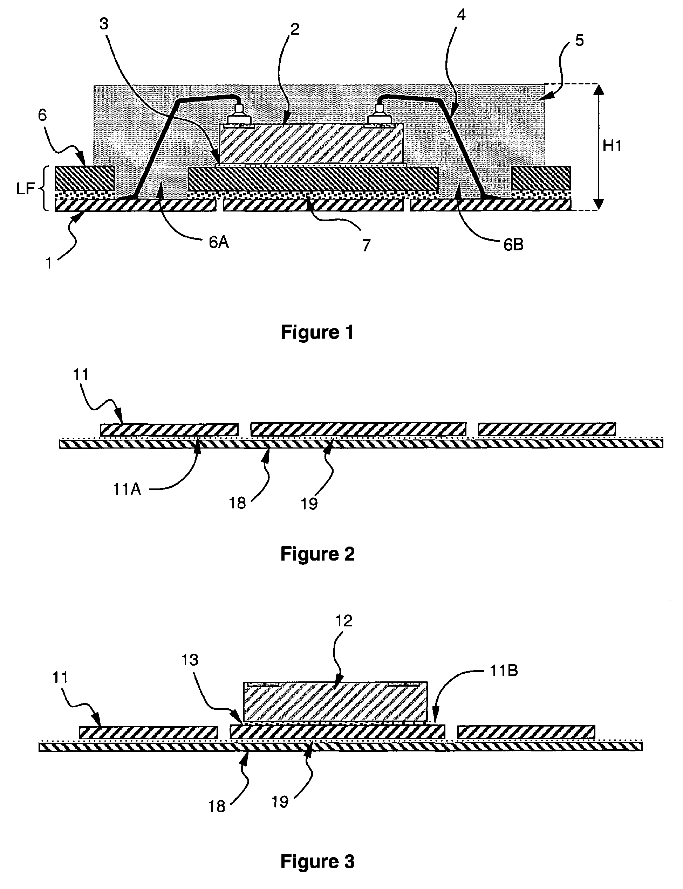

A known micro-electronic module adapted to be embedded in a smart-card is shown on Figure 1. The known micro-electronic module typically comprises a lead frame LF, a chip 2, connections 4 and an encapsulation 5. The lead frame LF comprises a metal grid 1 and a support layer 6 (e.g. made of a dielectric material). The support layer 6 comprises a certain number of holes 6A, 6B for connection purpose. The support layer is coupled to the metal grid by means of a first glue layer 7. The chip is coupled to the lead frame LF by a second glue layer 3 (e.g. an epoxy glue). The connections 4 (e.g. gold, aluminum or copper wires) connects the active portion of the chip 2 to particular portions of the metal grid 1 via the holes 6A, 6B. These particular portions of the metal grid 1 constitute contact pads for connecting the micro-electronic module to external device (not shown). The encapsulation 5 (e.g. an epoxy thermal or UV resins) protects the chip 2 and the connections 4.
Such a micro-electronic module is obtained according to a typical manufacturing method comprising the following steps.
During a first step, the support layer 6 comprising holes 6A, 6B is glued over the metal grid 1 through the first glue layer 7.
During a second step, the chip 2 is glued over the support layer 6 through the second glue layer 3.
During a third step, the chip 2 is wire bonded to the lead-frame, in particular to the metal grid 1 through the hole 6A, 6B by means of wire type connections 4.
During a fourth step, an encapsulation is performed over the chip 2 and the connections 4.

Generally, the fourth step is followed by curing and reticulation operations.

The dielectric layer ensures good lead-frame rigidity and avoids any glue and encapsulation resin leakage from the top side of the module (chip side) to the bottom side of the module (metal grid side), in particular before curing or reticulation process. Such a micro-electronic module has a height H1 of around 580µm which is not thin enough regarding the current trend of the smart-cards industry. In addition the whole manufacturing process is costly.

### SUMMARY OF THE INVENTION

One goal of the invention is to solve at least one shortcomings of the prior art, in particular to obtain a thinner micro-electronic module than the prior art micro-electronic module.

According to the invention, the permanent support layer and the first glue layer of prior art micro-electronic module are replaced by a temporary removable transportation layer. The transportation layer is present only during some of the first manufacturing steps and removed at the end of the manufacturing process. The finished micro-electronic module obtained with this manufacturing process comprises a chip glued over a front side of a metallic grid, connections connecting the chip to the front side of the metal grid, and an encapsulation.
The temporary transportation layer role is to avoid any chip glue or encapsulation resin leakage.

By suppressing the support layer (around 75µm) and its glue (around 20µm), a certain thickness of the finished micro-electronic module can be saved, e.g. about 20% of the total micro-electronic module thickness.

In addition, significant cost reduction can be achieved regarding the lead-frame raw material: the support layer (dielectric layer) and its glue are typically the most expensive parts of the lead-frame amounting for 50% of the lead-frame cost.

### BRIEF DESCRIPTION OF THE DRAWINGS

The present invention is illustrated by way of example and not limited to the accompanying figures, in which like references indicate similar elements:
Figure 1 schematically illustrates a micro-electronic module according to the prior art;
Figures 2 to 5 schematically illustrate a micro-electronic module of the invention according to various intermediate manufacturing steps;
Figure 6 schematically illustrates a micro-electronic module according to the invention at a final stage of the manufacturing process.

### DETAILED DESCRIPTION OF THE INVENTION

Figure 1 was already described in relation with the description of the background of the invention.

Figures 2 to 5 show a micro-electronic module for a smart-card according to the invention in various intermediate manufacturing steps.

Figure 2 shows a first gluing step. This step consists in gluing a transportation layer 18 over a back side 11A of a metallic grid 11 through a removable gluing layer 19. The transportation layer 18 can be made for example of PET (Poly-Ethylene Terephtalate) or PEN (Poly-Ethylene Naphtalate) material. The removable gluing layer may be epoxy glue. The metallic grid can be made of copper.
The thickness of the transportation layer and gluing layer can be chosen between 100µm and 200µm, depending of the rigidity and solidity required for the subsequent manufacturing steps. The thickness of the metallic grid is around 70µm.

Figure 3 shows a second gluing step consisting in gluing a chip 12 over a front side 11B of the metallic grid 11 through a chip gluing layer 13. The chip gluing layer may be epoxy glue.
The chip gluing layer being relatively fluid when applied, the transportation layer 18 avoids any chip gluing layer material leakage.
The thickness of the chip is around 185µm. The thickness of the chip gluing layer is around 30µm.

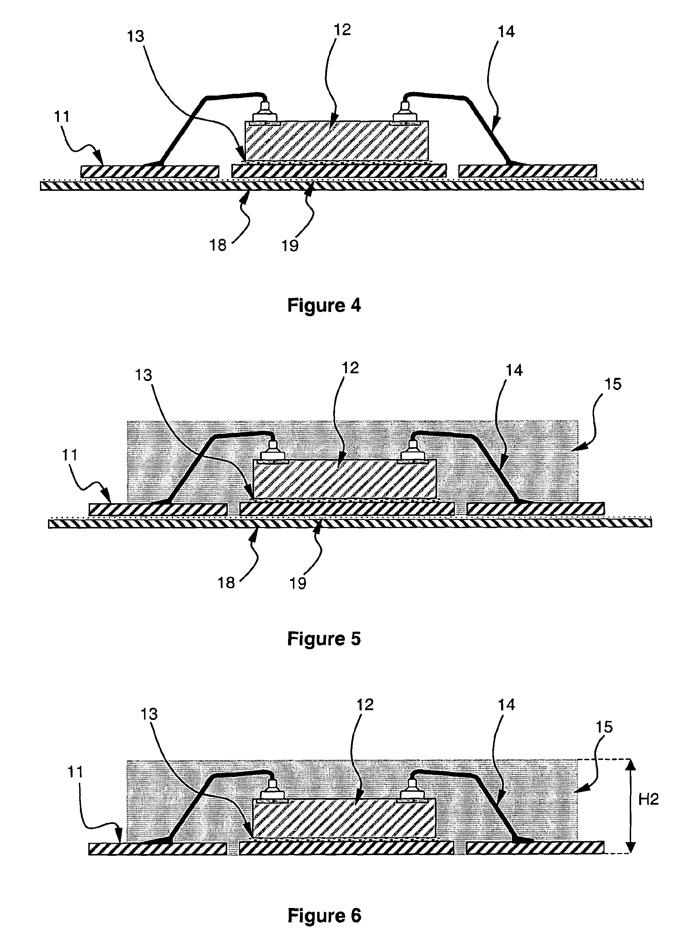

Figure 4 shows a connecting step consisting in bonding the chip 12 to the front side of the metal grid 11 by means of connections 14. These connections ensure electrical coupling between the active portions of the chip 12 to particular portions of the metal grid 11. These particular portions of the metal grid 11 constitute contact pad for connecting the micro-electronic module to external device (not shown). The connections 14 can be gold, copper or aluminum wires. The height of the connection above the chip surface is around 90µm.

Figure 5 shows an encapsulating step consisting in encapsulating the chip 12 and the connections 14. The encapsulation ensures the mechanical and electrical protection of the chip and the connections. The encapsulation material may be an UV or thermal resin applied by known techniques of glob top, molding, etc....
The encapsulation thickness is around 110µm above the connections.
The encapsulation material being relatively fluid when applied, the transportation layer 18 avoids any encapsulation material leakage. Thus, the transportation layer avoids any manufacturing equipment of getting dirty. Also, the transportation layer avoids the chip and connections of becoming incorrectly protected.

At this stage, an intermediate micro-electronic module for a smart-card shown in Figure 5 is obtained. It comprises the transportation layer 18 glued over the back side of the metallic grid 11 through the removable gluing layer 19, the chip 12 glued over the front side of the metallic grid 11 through the chip gluing layer 13, the connections 14 connecting the chip 12 to the metal grid 11, and the encapsulation 15 encapsulating the chip 12 and the connections 14.

Advantageously, further reticulation and curing operations are carried out. These operations transform the encapsulation material and gluing material from relatively fluid state to solid state.

Subsequently, the transportation layer 18 and the removable gluing layer 19 are removed from the back side of the metallic grid 11 during a removal step.
Preferably, the removal step is performed by peeling.
Alternatively, the removal step may be performed by chemical attack of the transportation layer and removable gluing layer.

At this stage, a finished micro-electronic module for a smart-card shown in Figure 6 is obtained. It comprises the chip 12 glued over the front side of the metallic grid 11 through the chip gluing layer 13, the connections 14 connecting the chip 12 to the front side of the metal grid 11, and the encapsulation 15 encapsulating the chip 12 and the connection 14.

By totally suppressing the support layer and its glue, a substantial thickness can be saved. In particular, more than 50% of the lead-frame thickness can be saved which corresponds to about 20% of the total micro-electronic module thickness.
The micro-electronic module thickness of the invention has a height H2 around 485µm, thus showing a gain of around 95µm in thickness compared to prior art micro-electronic module.

Finally, the micro-electronic module is embedded into a plastic card body so as to form a smart-card. Embedding techniques are well known in the smart-card industry (injection molding process, lamination process, etc...) and will not be further described.

As an alternative embodiment, the transportation layer 18 and the removable gluing layer 19 may be formed by a hot-melt adhesive layer. The hot-melt adhesive layer plays the role on the one side of the transportation layer in term of rigidity and protection regarding leakage of glue and encapsulation material, and on the other side of the removable gluing layer. The hot-melt adhesive layer is glued over the back side of the metallic grid (analogous to Figure 2) before microelectronic assembly (chip coupling and connection).

The drawings and their description hereinbefore illustrate rather than limit the invention.
Any reference sign in a claim should not be construed as limiting the claim. The word "comprising" does not exclude the presence of other elements than those listed in a claim. The word "a" or "an" preceding an element does not exclude the presence of a plurality of such element.

## Claims

1. A method for manufacturing a micro-electronic module for a smart-card comprising the following steps:
- a first gluing step consisting in gluing a transportation layer (18) over a back side (11 A) of a metallic grid (11) through a removable gluing layer (19),
- a second gluing step consisting in gluing a chip (12) over a front side (11B) of the metallic grid (11) through a chip gluing layer (13),
- a connecting step consisting in bonding the chip (12) to the front side of the metal grid (11) by means of at least one connection (14),
- an encapsulating step consisting in encapsulating the chip (12) and the connection (14), and
- a removal step consisting in removing the transportation layer (18) and the removable gluing layer (19) from the back side of the metallic grid (11).

2. A method for manufacturing a micro-electronic module for a smart-card according to claim 1, wherein the method further comprises a reticulation step and a curing step.

3. A method for manufacturing a micro-electronic module for a smart-card according to claim 1, wherein the transportation layer is removed by peeling.

4. A method for manufacturing a smart-card comprises the steps of manufacturing a micro-electronic module for a smart-card according to any one of the previous claims, and an embedding step consisting in embedding the micro-electronic module into a plastic card body.

5. An intermediate micro-electronic module for a smart-card comprising:
- a transportation layer (18) glued over a back side (11 A) of a metallic grid (11) through a removable gluing layer (19),
- a chip (12) glued over a front side (11B) of the metallic grid (11) through a chip gluing layer (13),
- at least one connection (14) connecting the chip (12) to the metal grid (11), and
- an encapsulation (15) encapsulating the chip (12) and the connections (14).

6. An intermediate micro-electronic module for a smart-card according to claim 5, wherein the transportation layer (18) is made of a material of the groups comprising Poly-Ethylene Terephtalate or Poly-Ethylene Naphtalate.

7. An intermediate micro-electronic module for a smart-card according to claim 5, wherein the transportation layer (18) and the removable gluing layer (19) are formed by a hot-melt adhesive layer.

8. A micro-electronic module for a smart-card comprising:
- a chip (12) glued over a front side (11A) of a metallic grid (11) through a chip gluing layer (13),
- at least one connection (14) connecting the chip (12) to the front side (11B) of the metal grid (11), and
- an encapsulation (15) for encapsulating the chip (12) and the connection (14).

9. A smart-card comprising a micro-electronic module according to claim 8 embedded into a plastic card body.
